Europäisches Patentamt

(19) European Patent Office

Office européen des brevets

(11) Publication number : **0 508 893 A1**

## (12) EUROPEAN PATENT APPLICATION

(21) Application number : **92400987.1**

(22) Date of filing : **08.04.92**

(51) Int. Cl.$^5$ : **H01L 39/22, H01L 39/24, C30B 29/68, C30B 29/22, C01B 13/14**

(30) Priority : **08.04.91 JP 103187/91**

(43) Date of publication of application :
**14.10.92 Bulletin 92/42**

(84) Designated Contracting States :
**DE FR GB NL**

(71) Applicant : **SUMITOMO ELECTRIC INDUSTRIES, LIMITED**
**5-33, Kitahama 4-chome Chuo-ku**
**Osaka (JP)**

(72) Inventor : **Tanaka, Saburo**
**Cabinet BALLOT-SCHMIT, 7 rue Le Sueur**
**F-75116 Paris (FR)**
Inventor : **Nakanishi, Hidenori**
**Cabinet BALLOT-SCHMIT, 7 rue Le Sueur**
**F-75116 Paris (FR)**
Inventor : **Itozaki, Hideo**
**Cabinet BALLOT-SCHMIT, 7 rue Le Sueur**
**F-75116 Paris (FR)**

(74) Representative : **Ballot, Paul Denis Jacques**
**Cabinet Ballot-Schmit, 7, rue le Sueur**
**F-75116 Paris (FR)**

(54) **Substrate for microwave component.**

(57)  A substrate for a microwave component, is composed of an underlying substrate, and a first oxide superconductor layer, a dielectric layer and a second oxide superconductor layer stacked on the underlying substrate in the named order. The dielectric layer is formed of a compound oxide thin film including La, Ca and Mn and having a perovskite crystalline structure.

# FIGURE 1

16 $YBa_2Cu_3O_y$

14 $La_{0.7}Ca_{0.3}Mn_{1.0}O_{3-x}$

12 $YBa_2Cu_3O_y$

10

$SrTiO_3(110)$ SUBSTRATE

EP 0 508 893 A1

## Background of the Invention

### Field of the invention

The present invention relates to a substrate for a microwave component, and more specifically to a microwave component Substrate which can be suitably used in forming a microwave component having a conductor line formed of a compound oxide superconducting thin film typified by a Cu-oxide type compound oxide.

### Description of related art

Electromagnetic waves called "microwaves" or "millimetric waves" having a wavelength in a range of a few tens centimeters to a few millimeters can be theoretically said to be merely a part of an electromagnetic wave spectrum, but have been considered from a viewpoint of an electric engineering to be a special independent field of the electromagnetic wave, since special and unique methods and devices have been developed for handling these electromagnetic waves. A microwave transmission line for guiding the electromagnetic waves in this band is generally formed of a pair of conductors separated from each other by a dielectric, one of the pair of conductors being grounded.

On the other hand, in 1986, Bednorz and Müller reported $(La, Ba)_2CuO_4$ showing a superconducting state at a temperature of 30 K. In 1987, Chu reported $YBa_2Cu_3O_y$ having a superconducting critical temperature on the order of 90 K, and in 1988, Maeda reported a so-call bismuth (Bi) type compound oxide superconducting material having a superconducting critical temperature exceeding 100 K. These compound oxide superconducting materials can obtain a superconducting with cooling using an inexpensive liquid nitrogen. As a result, possibility of actual application of the superconductor technology has become discussed and studied.

The compound oxide superconducting material had been, at a beginning, formed as a sintered body by a solid phase reaction process, but have now become possible to be formed in the form of a thin film, with advance of technology. In this connection, it has been known that the oxide superconducting thin film can have an effective superconducting characteristics only when it is deposited on a special underlying substrate.

Phenomenon inherent to the superconduction can be advantageously utilized in various applications, and the microwave components are no exceptions. For example, a microstrip line has an attenuation coefficient that is attributable to a resistance component of the conductor. This attenuation coefficient attributable to the resistance component increases in proportion to a root of a frequency. On the other hand, the dielectric loss increases in proportion to increase of the frequency. However, the loss of a recent microstrip line particularly in the range of not greater than 10 GHz is almost attributable to the resistance of the conductor, since the dielectric materials have been recently improved. Therefore, if the resistance of the conductor in the strip line can be reduced, it is possible to greatly elevate the performance of the microstrip line.

As well known, the microstrip line can be used as a simple signal transmission line. However, if a suitable patterning is applied, the microstrip line can be used as other microwave components including an inductor, a filter, a resonator, and a delayed line. therefore, improvement of the microstrip line will directly result in improvement of characteristics of these microwave components.

## Summary of the Invention

Accordingly, it is an object of the present invention to provide a novel microwave component substrate which can be suitably used in forming a microwave component having a conductor line formed of a compound oxide superconducting thin film typified by a Cu-oxide type compound oxide.

The above and other objects of the present invention are achieved in accordance with the present invention by a substrate for a microwave component, the substrate being composed of an underlying substrate, and a first oxide superconductor layer, a dielectric layer and a second oxide superconductor layer stacked on the underlying substrate in the named order, the dielectric layer being formed of a compound oxide thin film including La, Ca and Mn and having a perovskite crystalline structure.

As seen from the above, the substrate in accordance with the present invention for a microwave component is characterized in that dielectric layer sandwiched between a pair of oxide superconducting thin films which can constitute a conductor line, is formed of a thin film of compound oxide of La, Ca and Mn having a perovskite crystalline structure.

As mentioned hereinbefore, the microwave line can be formed of a pair of conductors sandwiching the dielectric therebetween, and therefore, various microwave components can be formed by appropriately patterning one or both of the pair of conductors. Therefore, if it is possible to supply a substrate constituted of a pair of conductor layers and a dielectric layer therebetween stacked on a whole of a surface of an underlying substrate, it would become possible to simply form various microwave components.

On the other hand, the substrate for a microwave component having a pair of oxide superconducting thin films as a conductor layer can be obtained by depositing on an underlying substrate a first oxide superconducting thin film, a dielectric layer and a second oxide superconducting thin film in the named order. However, if an oxide superconducting thin film is deposited on a usual dielectric thin film, superconducting property of the deposited oxide superconducting thin film is remarkably deteriorated, and therefore, it cannot be used as a superconducting conductor line.

It is known that the compound oxide of La, Ca and Mn used as the material of the dielectric layer in the substrate in accordance with the present invention for a microwave component, forms a perovskite crystalline structure under a composition ratio of $La_{0.7}Ca_{0.3}Mn_{1.0}O_{3-X}$. Under this composition ratio, the compound oxide of La, Ca and Mn has a lattice constant of 3.87, which is extremely near to the lattice constant 3.82/3.89 of the Y-Ba-Cu type oxide superconductor. In addition, this compound oxide can be deposited in the form of a thin film having an excellent surface smoothness by selecting an appropriate deposition condition. Therefore, if a $La_{0.7}Ca_{0.3}Mn_{1.0}O_{3-X}$ thin film is used as an underlying layer, an oxide superconducting thin film of Y-Ba-Cu type oxide or other oxide superconductor materials can be crystal-grown with a film property which is not inferior to an oxide superconducting thin film directly deposited on a single crystal underlying substrate.

In the substrate in accordance with the present invention for a microwave component, since the $La_{0.7}Ca_{0.3}Mn_{1.0}O_{3-X}$ thin film is used as the dielectric layer, the second oxide superconducting thin film deposited on the dielectric layer has a film property making it possible to use the second oxide superconducting thin film as the conductor line.

In addition, the underlying substrate can be formed of a known single crystal such as an MgO single crystal, a $SrTiO_3$ single crystal a $LaAlO_3$ single crystal, etc., and the first and second oxide superconducting thin films can be formed of a Cu-oxide type compound oxide such as Y type compound oxide, Bi type compound oxide, Tl type compound oxide, etc.

The above and other objects, features and advantages of the present invention will be apparent from the following description of preferred examples of the invention with reference to the accompanying drawings. However, the examples explained hereinafter are only for illustration of the present invention, and therefore, it should be understood that the present invention is in no way limited to the following examples.

## Brief Description of the Drawings

Figure 1 is a diagrammatic sectional view of a microwave component substrate in accordance with the present invention; and

Figure 2 is a diagrammatic perspective view illustrating a patterned signal conductor of a superconduction microwave resonator formed by utilizing the microwave component substrate in accordance with the present invention.

## Description of the Preferred embodiments

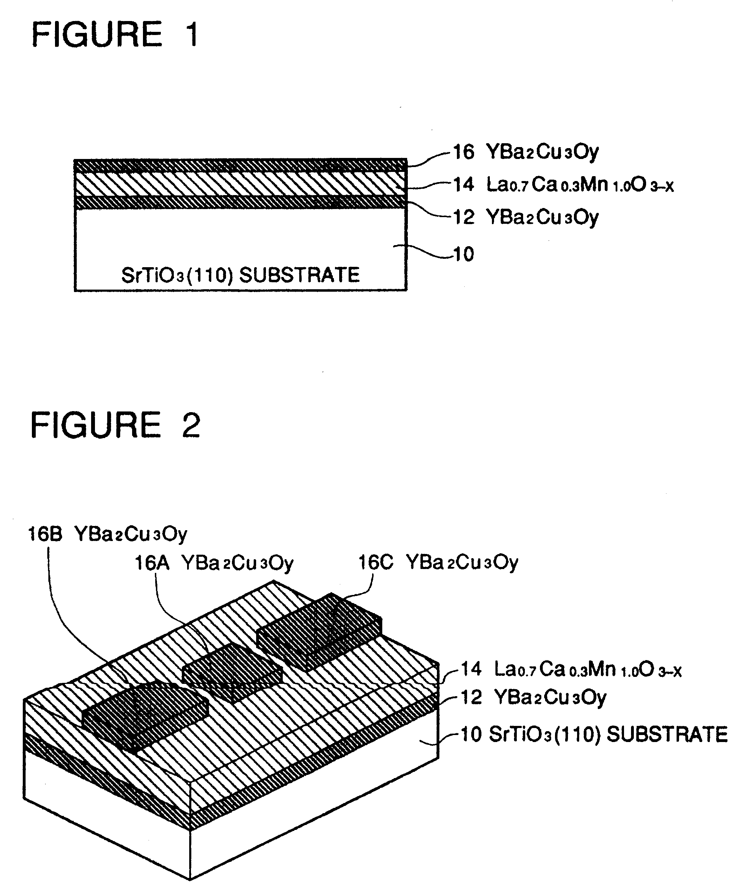

As shown in Figure 1, a microwave component substrate in accordance with the present invention was manufactured by using a $SrTiO_3$ (110) single crystal substrate 10 and an Y-Ba-Cu type compound oxide ($YBa_2Cu_3O_y$ ($6 < y \leqq 7$)) as an underlying substrate and an oxide superconductor material, and by depositing a first oxide superconducing thin film 12, a dielectric layer 14 and a second oxide superconducting thin film 16 in the named order

First, the first oxide superconducting thin film 12 was formed by depositing an Y-Ba-Cu type compound oxide thin film on the underlying substrate 10 by a magnetron sputtering method. The deposition condition is as follows:

| | |
|---|---|
| Target | : compound oxide sintered body |
| | Y:Ba:Cu = 1.0 : 2.0 : 3.8 |
| | (atomic ratio) |
| Substrate temperature | : 620°C |
| Sputtering gas | : Mixed gas of Ar and $O_2$ |
| | $(O_2/Ar+O_2)$ = 0.2 (volume ratio) |
| Gas pressure | : 20mTorr |
| Deposition speed | : 1000 Å/hour |
| Film thickness | : 2000 Å |

Next, the dielectric layer 14 is formed by depositing an $La_{0.7}Ca_{0.3}Mn_{1.0}O_{3-X}$ thin film on the Y-Ba-Cu type compound oxide thin film 12 also by a magnetron sputtering method. The deposition condition is as follows:

| Target | : $La_{0.7}Ca_{0.3}Mn_{1.0}O_y$ |
| Substrate temperature | : 629°C |
| Sputtering gas | : Mixed gas of Ar and $O_2$ |
| | $(O_2/Ar+O_2) = 0.2$ (volume ratio) |
| Gas pressure | : 20 mTorr |
| Deposition speed | : 700 Å/hour |
| Film thickness | : 10 μm |

Then, the second oxide superconducting thin film 16 was formed by depositing an Y-Ba-Cu type compound oxide thin film on the $La_{0.7}Ca_{0.3}Mn_{1.0}O_{3-x}$ thin film 14 also by a magnetron sputtering method. The deposition condition is the same as that for the first oxide superconducting thin film.

The critical temperature and the critical current density of the second oxide superconducting thin film 16 in the microwave component substrate thus formed were measured. The critical temperature was 90 K, and the critical current density at 77 K was $5 \times 10^6$ $A/cm^2$.

In addition, a microwave resonator was formed by using the microwave component substrate thus formed. As shown in Figure 2, the second oxide superconducting thin film of the microwave component substrate was patterned by an etching so as to form a center signal conductor line 16A having a width of 20 μm and a length of 20 μm and a pair of launching signal conductor lines 16B and 16C having a width of 20 μm and separated from the center signal conductor line 16A by 10 μm. Characteristics of the microwave resonator were measured at 77 K. For a microwave of 4.5 GHz, the Q factor was 40000, and the transmission loss was 10 dB.

As seen from the above, since the microwave component substrate in accordance with the present invention includes the dielectric layer composed of a La-Ca-Mn compound oxide, an excellent superconducting property of the overlying oxide superconductor is exerted. In addition, since the microwave component substrate in accordance with the present invention makes it possible to use the microwave component by cooling of liquid nitrogen, utilisation of wide and various fields can be expected.

In the above mentioned embodiment, the Cu-oxide type compound oxide superconducting thin film is formed of the Y-Ba-Cu type compound oxide superconducting material, which is a typical one of a so-called high-Tc Cu-oxide type superconducting material which has been studied by many researchers since the discovery of Bednorz and Müller in 1986, and is said to indicate an oxide superconducting material having a critical temperature of not less than 30K. Therefore, it could be understood that the material of the Cu-oxide type compound oxide superconducting thin film is not limited to the Y-ba-Cu type compound oxide superconducting material, but the Cu-oxide type compound oxide superconducting thin film can be formed of any other high-Tc Cu-oxide type superconducting material including a Bi-Sr-Ca-Cu type compound oxide superconducting material and a Tl-Ba-Ca-Cu type compound oxide superconducting material.

The invention has thus been shown and described with reference to the specific embodiments. however, it should be noted that the present invention is in no way limited to the details of the illustrated structures but changes and modifications may be made within the scope of the appended claims.

## Claims

1. A substrate for a microwave component, the substrate being composed of an underlying substrate, and a first oxide superconductor layer, a dielectric layer and a second oxide superconductor layer stacked on said underlying substrate in the named order, said dielectric layer being formed of a compound oxide thin film including La, Ca and Mn and having a petovskite crystalline structure.

2. A substrate claimed in Claim 1 wherein said compound oxide thin film including La, Ca and Mn has a composition of $La_{0.7}Ca_{0.3}Mn_{1.0}O_{3-x}$.

3. A substrate resonator claimed in Claim 1 wherein said underlying substrate is formed of a material from a group consisting of an MgO single crystal, a $SrTiO_3$ single crystal and a $LaAlO_3$ single crystal.

4. A microwave resonator claimed in Claim 1 wherein each of said first and second oxide superconducting film is formed of a material from a group consisting of Y type compound oxide, Bi type compound oxide and T1 type compound oxide.

5. A microwave resonator claimed in Claim 1 wherein said underlying substrate is formed of a $SrTiO_3$ (110) single crystal substrate, and each of said first and second oxide superconducting film is formed of $YBa_2Cu_3O_y$ ($6 < y \leqq 7$).

## FIGURE 1

16 $YBa_2Cu_3Oy$
14 $La_{0.7}Ca_{0.3}Mn_{1.0}O_{3-x}$
12 $YBa_2Cu_3Oy$
10
$SrTiO_3(110)$ SUBSTRATE

## FIGURE 2

16B $YBa_2Cu_3Oy$

16A $YBa_2Cu_3Oy$

16C $YBa_2Cu_3Oy$

14 $La_{0.7}Ca_{0.3}Mn_{1.0}O_{3-x}$
12 $YBa_2Cu_3Oy$
10 $SrTiO_3(110)$ SUBSTRATE

EP 0 508 893 A1

## EUROPEAN SEARCH REPORT

European Patent Office

Application Number

| DOCUMENTS CONSIDERED TO BE RELEVANT | | | EP 92400987.1 |
|---|---|---|---|
| Category | Citation of document with indication, where appropriate, of relevant passages | Relevant to claim | CLASSIFICATION OF THE APPLICATION (Int. Cl.5) |
| P,A | PATENT ABSTRACTS OF JAPAN, unexamined applications, C field, vol. 15, no. 238, June 19, 1991 THE PATENT OFFICE JAPANESE GOVERNMENT page 154 C 841 * Kokai-no. 3-75 300 (HITACHI) * -- | 1,4,5 | H 01 L 39/22 H 01 L 39/24 C 30 B 29/68 C 30 B 29/22 C 01 B 13/14 |
| A | PATENT ABSTRACTS OF JAPAN, unexamined applications, E field, vol. 15, no. 3, January 7, 1991 THE PATENT OFFICE JAPANESE GOVERNMENT page 43 E 1019 * Kokai-no. 2-257 529 (KOKUSHAI CHIYOUDENDOU) * ---- | 1,3-5 | |
| | | | TECHNICAL FIELDS SEARCHED (Int. Cl.5) H 01 L 39/00 C 30 B 29/00 C 01 B 13/00 |

The present search report has been drawn up for all claims

| Place of search | Date of completion of the search | Examiner |
|---|---|---|
| VIENNA | 01-07-1992 | HOFBAUER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)